# EUROPEAN PATENT APPLICATION

(11) **EP 4 053 829 A1**
(43) Date of publication of application: **07.09.2022**
(21) Application number: 19951069.4
(22) Date of filing: 29.11.2019
(51) Int. Cl.: G09F 11/02, G09F 11/10, G09F 9/33

(54) **ROTATING DISPLAY APPARATUS USING SEMICONDUCTOR LIGHT-EMITTING DEVICE**

(30) Priority: 30.10.2019 KR 20190136835
(71) Applicant: LG Electronics Inc., SEOUL 07336 (KR)
(72) Inventor: PARK, Seongjin, Seoul 08592 (KR)
(74) Representative: Vossius & Partner Patentanwälte Rechtsanwälte mbB
(86) International application number: PCT/KR2019/016698
(87) International publication number: WO 2021/085733

(57) **Abstract**

The present disclosure is applicable to a display apparatus-related technical field, and relates to, for example, a rotating display apparatus using a light-emitting diode (LED) which is a semiconductor light-emitting device. The rotating display apparatus using a light-emitting device of the present disclosure may comprise: a fixed part including a motor; a rotary part positioned on the fixed part and coupled to a rotary shaft of the motor so as to rotate; a first light source module installed on the rotary part and including at least one first panel disposed on an outer peripheral surface of an imaginary cylinder in the same direction as the rotary shaft, and a first light-emitting device array in which individual pixels are disposed on respective first panels in the length direction of the first panel; and a second light source module installed on the rotary part and including at least one second panel disposed in a direction perpendicular to the rotary shaft, and a second light-emitting device array in which individual pixels are disposed on respective second panels.

## Description

### TECHNICAL FIELD

The present disclosure is applicable to display-device-related technical fields, and relates to a rotating display device using a light-emitting diode (LED), which is a semiconductor light-emitting element.

### BACKGROUND ART

Recently, in the field of display technology, display devices having excellent characteristics, such as thinness and flexibility, have been developed. Meanwhile, currently commercialized major displays are represented by a liquid crystal display (LCD) and an organic light-emitting diode (OLED).

However, the LCD has problems in which the response time is slow and it is difficult to realize flexibility, and the OLED has problems in which the lifespan thereof is short and the production yield thereof is low.

Meanwhile, a light-emitting diode (LED), which is a well-known semiconductor light-emitting element that converts current into light, has been used as a light source for displaying an image in electronic devices including information communication devices together with a GaP:N-based green LED, starting with commercialization of a red LED using a GaAsP compound semiconductor in 1962. Therefore, a method of solving the above-described problems by implementing a display using the semiconductor light-emitting element may be proposed. Such a light-emitting diode has various advantages, such as a long lifespan, low power consumption, excellent initial driving characteristics, and high vibration resistance, compared to a filament-based light-emitting element.

When a light-emitting module including such light-emitting elements disposed therein along one dimension is rotated and driven at high speed depending on the angle thereof, various characters, graphics, and even videos can be reproduced through the human afterimage effect.

In general, when still images are continuously displayed at a rate of 24 or more sheets per second, a viewer recognizes the same as a video. A conventional image display device, such as a CRT, an LCD, or a PDP, displays still images at a rate of 30 to 60 frames per second, so a viewer is capable of recognizing the same as a video. As the number of still images displayed per second increases, a viewer may experience smoother video.

Meanwhile, since a person's field-of-view is formed in a direction perpendicular to a light source module, there may be limitations on expression of a three-dimensional effect using the above-described rotating display device. Accordingly, there is a need for a method of improving the three-dimensional effect.

### DISCLOSURE

### TECHNICAL TASK

One technical task of the present disclosure is to provide a rotating display device using a semiconductor light-emitting element capable of improving a three-dimensional effect of the rotating display device.

Another technical task of the present disclosure is to provide a rotating display device using a semiconductor light-emitting element capable of expressing various screen configurations of the rotating display device.

### TECHNICAL SOLUTIONS

In accordance with an aspect of the present disclosure, the above and other objects can be accomplished by the provision of a rotating display device using a light-emitting element, the rotating display device including a fixed portion comprising a motor, a rotary portion located on the fixed portion and coupled to a rotary shaft of the motor so as to rotate, a first light source module disposed at the rotary portion, the first light source module comprising one or more first panels, disposed on an outer rotational circumference of the rotary portion in the same direction as the rotary shaft, and wherein each first panel comprises a first light-emitting element array comprising individual pixels disposed along a longitudinal direction of the first panel, and a second light source module disposed at the rotary portion, the second light source module comprising one or more second panels, disposed in a direction perpendicular to the rotary shaft, wherein each second panel comprises a second light-emitting element array comprising individual pixels disposed on the second panel.

Further, the second light source module may have a disk shape.

Further, each second light-emitting element array may be radially disposed from a center of the second light source module.

In addition, the number of second light-emitting element arrays may be the same as the number of first light-emitting element arrays.

In addition, each of the second light-emitting element arrays may be located between the adjacent first light-emitting element arrays.

Additionally, the one or more first panels of the light source module may extend between a first side and a second side of the rotary portion.

Additionally, the one or more second panel may include one or more upper panel located at the first side of the rotary portion and one or more lower panel located at the second side of the rotary portion.

Further, the one or more second panels may be inclined with respect to a direction perpendicular to the rotary shaft.

Further, the second panel may have a central portion and a peripheral portion different in height in the direction perpendicular to the rotary shaft.

Further, the second light source module may have a conical shape.

In accordance with another aspect of the present disclosure, there is provided a rotating display device using a light-emitting element, the rotating display device including a fixed portion comprising a motor, a rotary portion located on the fixed portion and coupled to a rotary shaft of the motor so as to rotate, a first light source module disposed at the rotary portion, the first light source module comprising one or more first panels each elongated between a first side and a second side of the rotary portion, wherein each first panel comprises a first light-emitting element array comprising individual pixels disposed along a longitudinal direction of the first panel, and a second light source module disposed at the rotary portion, the second light source module comprising one or more second panels, disposed on at least one of the first side or the second side of the rotary portion, wherein each second panel comprises a second light-emitting element array comprising individual pixels disposed on the second panel.

The first light source module may be disposed on a virtual cylindrical outer circumferential surface formed by the rotary portion in the same direction as the rotary shaft.

Further, the second light source module may be disposed in a direction perpendicular to the rotary shaft.

In addition, the second light source module may have a disk shape or a conical shape.

Additionally, each second light-emitting element array may be radially disposed from a center of the second light source module.

### ADVANTAGEOUS EFFECTS

According to an embodiment of the present disclosure, the following effects are obtained.

According to the present disclosure, a rotating display device including a first light source module and a second light source module may further improve a three-dimensional effect by implementing a screen display on a surface of a cylindrical rotary body and a bottom surface of the rotary body.

In addition, according to an implementation example of a display screen, a rotating display device according to an embodiment of the present disclosure may further improve the three-dimensional effect by implementing the screen display on the surface of the cylindrical rotary body and an inclined surface of a bottom side of the rotary body.

Further, according to the implementation example of the display screen, the rotating display device according to the embodiment of the present disclosure may further improve the three-dimensional effect by implementing the screen display on the surface of the cylindrical rotary body, the inclined surface of the bottom side of the rotary body, and an inclined surface of an upper side of the rotary body.

Additionally, it is possible to implement a display capable of various screen configurations using the surface of the cylindrical rotary body and the inclined surfaces of the bottom side of the rotary body and the upper side of the rotary body.

Further, the present disclosure also has additional technical effects not mentioned herein, and those skilled in the art can understand these effects based on the entirety of the specification and the drawings.

### DESCRIPTION OF DRAWINGS

FIG. 1 is an external perspective view showing a rotating display device according to a first embodiment of the present disclosure.
FIG. 2 is a cross-sectional view of the rotating display device according to the first embodiment of the present disclosure.
FIG. 3 is a top plan view of the rotating display device according to the first embodiment of the present disclosure.
FIG. 4 is a perspective view showing the front surface of a light source module according to the present disclosure.
FIG. 5 is a perspective view showing the rear surface of the light source module according to the present disclosure.
FIG. 6 is an enlarged view of portion A in FIG. 4.
FIG. 7 is a cross-sectional view of the light source module according to the present disclosure.
FIG. 8 is a block diagram of the rotating display device according to the present disclosure.
FIG. 9 is an external perspective view showing a rotating display device according to a second embodiment of the present disclosure.
FIG. 10 is a perspective view showing a second light source module of the rotating display device according to the second embodiment of the present disclosure.
FIG. 11 is a perspective view of a rotating display device according to a third embodiment of the present disclosure, seen from above.
FIG. 12 is a perspective view of the rotating display device according to the third embodiment of the present disclosure, seen from below.
FIG. 13 is a side view of the rotating display device according to the third embodiment of the present disclosure.
FIGs. 14 and 15 are views showing an example of a screen configuration of the rotating display device according to the third embodiment of the present disclosure.

### BEST MODE FOR DISCLOSURE

Reference will now be made in detail to embodiments of the present disclosure, examples of which are illustrated in the accompanying drawings. Wherever possible, the same reference numbers will be used throughout the drawings to refer to the same or like parts, and a redundant description thereof will be omitted. As used herein, the suffixes "module" and "unit" are added or used interchangeably to facilitate preparation of this specification, and are not intended to suggest distinct meanings or functions. In describing embodiments disclosed in this specification, relevant well-known technologies may not be described in detail in order to avoid obscuring the subject matter of the embodiments disclosed in this specification. In addition, it should be noted that the accompanying drawings are only for easy understanding of the embodiments disclosed in the present specification, and should not be construed as limiting the technical spirit disclosed in the present specification.

Furthermore, although the drawings are separately described for simplicity, embodiments implemented by combining two or more drawings are also within the scope of the present disclosure.

In addition, when an element such as a layer, a region, or a substrate is described as being "on" another element, it is to be understood that the element may be directly on the other element, or there may be an intermediate element between them.

The display device described herein conceptually includes all display devices that display information with a unit pixel or a set of unit pixels. Therefore, the term "display device" may be applied not only to finished products but also to parts. For example, a panel corresponding to a part of a digital TV also independently corresponds to the display device in the present specification. Such finished products include a mobile phone, a smartphone, a laptop computer, a digital broadcasting terminal, a personal digital assistant (PDA), a portable multimedia player (PMP), a navigation system, a slate PC, a tablet PC, an Ultrabook, a digital TV, a desktop computer, and the like.

However, it will be readily apparent to those skilled in the art that the configuration according to the embodiments described herein is also applicable to new products to be developed later as display devices.

In addition, the term "semiconductor light-emitting element" mentioned in this specification conceptually includes an LED, a micro LED, and the like, and may be used interchangeably therewith.

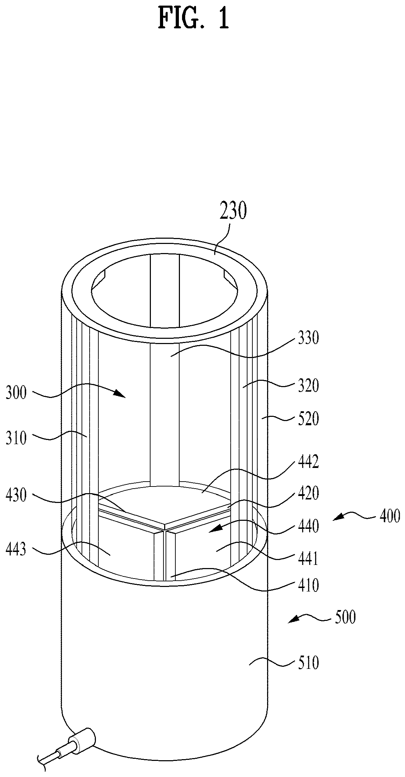

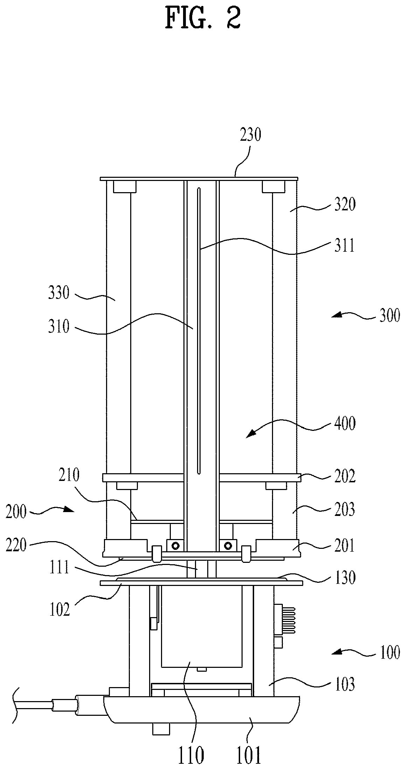

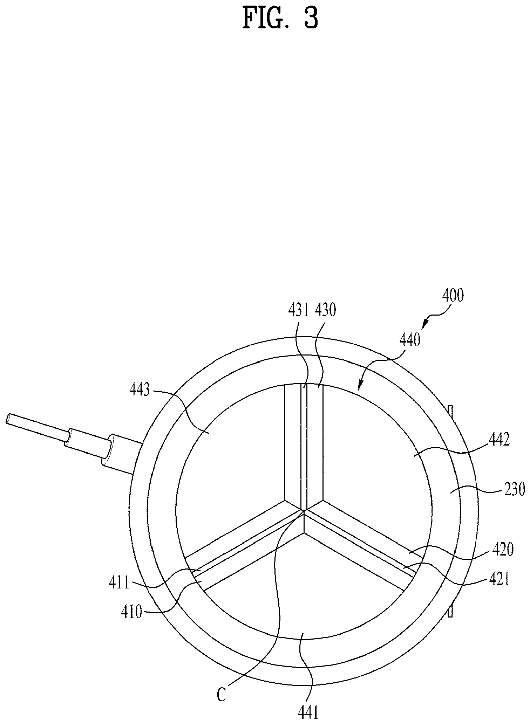

FIG. 1 is an external perspective view showing a rotating display device according to a first embodiment of the present disclosure. FIG. 2 is a cross-sectional view of the rotating display device according to the first embodiment of the present disclosure. FIG. 3 is a top plan view of the rotating display device according to the first embodiment of the present disclosure.

The rotating display device according to the first embodiment of the present disclosure will be described with reference to FIGs. 1 to 3. Here, FIG. 2 shows a cross-section of an internal structure excluding an outer casing 500 in FIG. 1. In addition, FIG. 3 shows a state viewed from the top of FIG. 1.

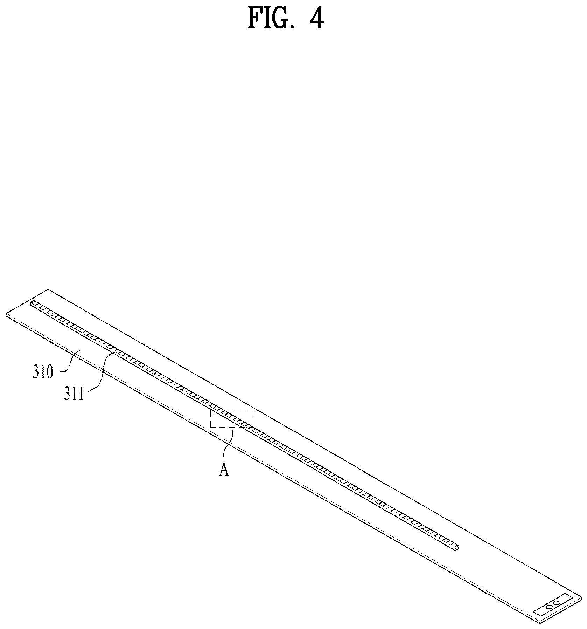

FIG. 1 shows the cylindrical rotating display device including a first light source module 300 in which each of the light-emitting element arrays 311, 321, and 331 (refer to FIG. 4; hereinafter, referred to as a first light-emitting element array) is provided on each of one or more panels 310, 320, and 330 (hereinafter, referred to as a first panel), disposed along a virtual cylindrical outer circumferential surface, in a longitudinal direction of each of the first panels, and a second light source module 400 including one or more second panels 410, 420, and 430 and second light-emitting element arrays 411, 421, and 431 located on the second panels 410, 420, and 430, the second light-emitting element arrays 411, 421, and 431 including individual pixels disposed therein in the longitudinal direction of the second panels 410, 420, and 430.

The rotating display device may broadly include a fixed portion 100 including a motor 110, a rotary portion 200 located on the fixed portion 100 and rotated by the motor 110, and a light source module 300 (hereinafter, referred to as the first light source module), the light source module 300 being coupled to the rotary portion 200, including the light-emitting element arrays 311, 321, and 331 respectively installed on the first panels 310, 320, and 330, and implementing a display by displaying an afterimage by rotation thereof.

The first light source module 300 may be installed so as to be oriented in the same direction as a rotary shaft around which the rotary portion 200 rotates.

In this case, the first light source module 300 may include the first light-emitting element arrays 311, 321, and 331 installed on one or more bar-shaped panels 310, 320, and 330, which are provided on the cylindrical outer circumferential surface of the first light source module 300 at a predetermined distance, in the longitudinal direction thereof.

As shown in FIGs. 1 and 2, the first light source module 300 may include the three panels 310, 320, and 330 including the light-emitting element arrays 311, 321, and 331 provided thereon. However, this is an example, and the first light source module 300 may include one or more panels.

The first light-emitting element arrays 311, 321, and 331 may include individual pixels disposed on each of the panels 310, 320, and 330 in the longitudinal direction. A detailed description of the driving of the first light-emitting element arrays 311, 321, and 331 provided in the first light source module 300 will be omitted.

Each of the first panels 310, 320, and 330 provided in the first light source module 300 may form a printed circuit board (PCB). That is, each of the first panels 310, 320, and 330 may have the function of a printed circuit board. The first light-emitting element arrays 311, 321, and 331 may form individual unit pixels on the first panels 310, 320, and 330, respectively, and may be disposed in the longitudinal direction of the panels.

The first panels 310, 320, and 330 including the first light-emitting element arrays 311, 321, and 331 respectively provided thereon may rotate to implement a display using an afterimage. Implementation of the display using the afterimage will be briefly described below.

As described above, the first light source module 300 may include a plurality of panels 310, 320, and 330, but may also be implemented as one panel including a light-emitting element array. However, when the first light source module 300 is implemented by the three first panels 310, 320, and 330, as shown in the example of FIG. 1, one frame image may be implemented by dividing the same using the three first panels. Accordingly, the rotation speed of the first light source module 300 may be reduced compared to the rotation speed of the case in which the one frame image is implemented by one first panel.

A plurality of first light source modules 300 may be installed between a first side (lower side) 202 of the rotary portion 200 and a second side (upper side) 230 thereof in the longitudinal direction.

Meanwhile, the second light source module 400, installed in the rotary portion 200 and disposed in a direction perpendicular to the rotary shaft of the rotary portion 200, may be further provided. That is, the second light source module 400 may be installed in a direction perpendicular to the first light source module 300. In other words, the second light source module 400 may be installed in a direction parallel to the first side of the rotary portion 200 (lower side; upper frame 202) or the second side thereof (upper side; cover frame 230).

As described above, the second light source module 400 may include one or more second panels 410, 420, and 430 and the second light-emitting element arrays 411, 421, and 431 located on the second panels 410, 420, and 430, the second light-emitting element arrays 411, 421, and 431 including the individual pixels disposed therein in the longitudinal direction of the second panels 410, 420, and 430.

FIGs. 1 to 3 show an example in which the second light source module 400 is provided on a lower panel 440 installed on the upper frame 202 located at a lower side of the rotary portion 200. However, as described in another example below, the second light source module 400 may be further provided on an upper panel 450 installed on the cover frame 230 of the rotary portion 200. This will be described in connection with another embodiment.

As shown in the drawing, the second light source module 400 may have a disk shape. That is, the lower panel 440 provided as the second light source module 400 may also have a disk shape. In this case, a central point C of the lower panel 440 may have the same height as a peripheral portion thereof.

In this case, the second light-emitting element arrays 411, 421, and 431 may be radially disposed on the disk-shaped lower panel 440 from the central point C of the lower panel 440. That is, the second light source module 400 may include the second panels 410, 420, and 430 radially provided therein, and the second light-emitting element arrays 411, 421, and 431 may be disposed in the longitudinal direction of the second panels 410, 420, and 430, respectively.

The number of second panels 410, 420, and 430 and second light-emitting element arrays 411, 421, and 431 may be the same as the number of first light-emitting element arrays 311, 321, and 331. Since the second light-emitting element arrays 411, 421, and 431 rotate at substantially the same rotational speed as the first light-emitting element arrays 311, 321, and 331, it is preferable that the second light-emitting element arrays 411, 421, and 431, and the first light-emitting element arrays 311, 321, and 331 be provided in the same number.

For example, as described in the embodiment, when the number of first light-emitting element arrays 311, 321, and 331 is three, three second light-emitting element arrays 411, 421, and 431 may be provided.

In addition, as shown in the drawing, each of the second light-emitting element arrays 411, 421, and 431 may be disposed between adjacent first light-emitting element arrays 311, 321, and 331.

The lower panel 440 may be formed by respective partial panels 441, 442, and 443, the respective partial panels 441, 442, and 443 having arc shapes and being coupled to each other to form a disk shape. That is, as shown in FIG. 3, the three partial panels 441, 442, and 443 having the arc shapes and the second panels 410, 420, and 430 located therebetween may be coupled to each other to form the lower panel 440.

However, this is an example, and the second panels 410, 420, and 430 may be coupled to each other on a panel having a disk shape to form the lower panel 440.

The rotating display device including the first light source module 300 and the second light source module 400 may improve a three-dimensional effect by implementing a screen display on a surface of a cylindrical rotary body and a bottom surface of the rotary body.

Meanwhile, the fixed portion 100 may include frame structures 101, 102, and 103. That is, the fixed portion 100 may include a lower frame 101, an upper frame 102, and a connection frame 103 connecting the lower frame 101 to the upper frame 102.

The frame structures 101, 102, and 103 may provide a space having the motor 110 installed therein, and may also provide a space having a power supply unit 120 and an RF module 126 installed therein.

In addition, the fixed portion 100 may include a weight (not shown) installed therein to reduce the influence of high-speed rotation of the rotary portion 200.

In the same manner, the rotary portion 200 may include frame structures 201, 202, and 203. That is, the rotary portion 200 may include the lower frame 201, the upper frame 202, and the connection frame 203 connecting the lower frame 201 and the upper frame 202. In addition, the cover frame 230 may be located above the upper frame 202. As described above, the first light source module 300 may be installed between the upper frame 202 and the cover frame 230 in the longitudinal direction.

The frame structures 201, 202, and 203 may provide a space in which a driving circuit 210 configured to drive the first light-emitting element arrays 311, 321, and 331 is installed so as to implement a display.

In this case, a driving shaft 111 of the motor 110 may be coupled to the first side of the rotary portion 200. Here, the first side of the rotary portion 200 may be the lower frame 201 located at a lower side of the rotary portion 200. Hereinafter, the case in which the lower side (first side) of the rotary portion 200 coupled to the motor 110 is the lower frame 201 will be described by way of example. However, the present disclosure is not limited thereto.

More specifically, the driving shaft 111 of the motor 110 may be fixed to a shaft-fixing unit 204 formed in the lower frame 201. Accordingly, the driving shaft 111 of the motor 110 and the center of rotation of the rotary portion 200 may be located on the same axis. As such, the lower side of the rotary portion 200 may be coupled to the driving shaft 111 of the motor 11.

Meanwhile, referring to FIG. 1, the fixed portion 100, the rotary portion 200, the first light source module 300, and the casing 500 located outside the second light source module 400 may be provided.

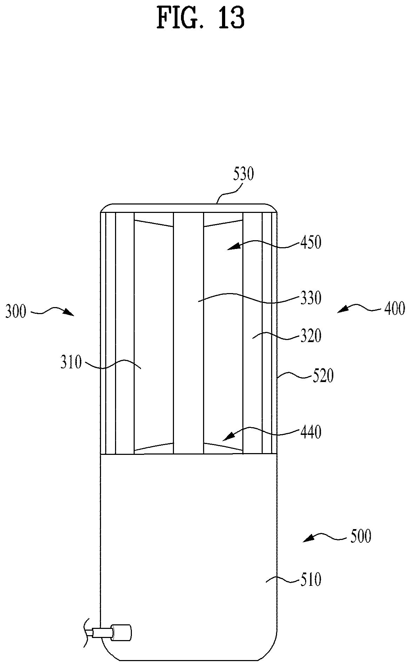

In this case, the casing 500 may include an opaque portion 510 located outside the fixed portion 100, a transparent portion 520 located outside the first light source module 300, and a cover portion 530 located at the upper side of the transparent portion 520 and configured to cover an upper surface of the casing 500 (refer to FIG. 13).

Power may be transmitted between the fixed portion 100 and the rotary portion 200 in a wireless power transmission method. To this end, a transmission coil 130, configured to transmit wireless power, may be installed on the upper side of the fixing unit 100, and a reception coil 220, disposed at a location facing the transmission coil 130, may be installed at a lower side of the rotary portion 200.

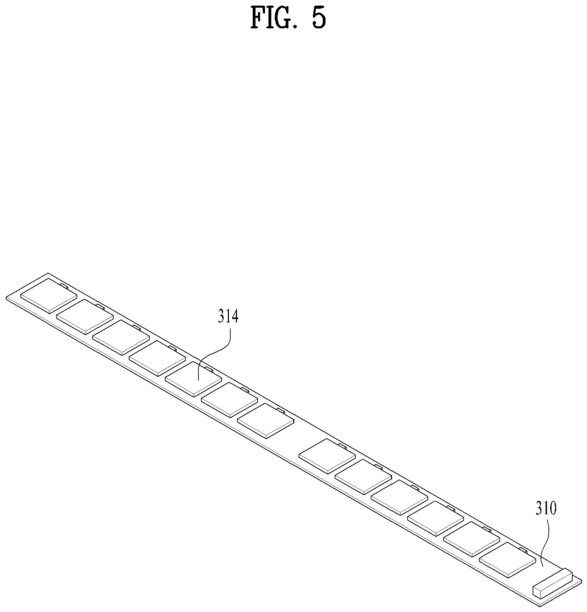

FIG. 4 is a perspective view showing the front surface of the light source module according to the present disclosure, and FIG. 5 is a perspective view showing the rear surface of the light source module according to the present disclosure.

FIGs. 4 and 5 show the first panel 310 of the first light source module 300 as an example, and the same may apply to the other panels 320 and 330. Further, the same may apply to the second panels 410, 420, and 430 of the second light source module 400. That is, the second panels 410, 420, and 430 of the second light source module 400 may also have the same structure as shown in FIGs. 4 and 5.

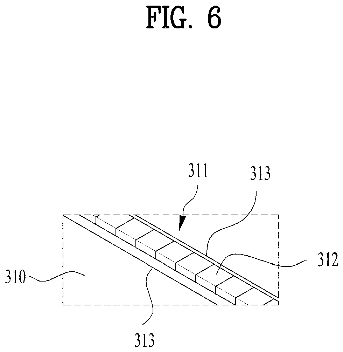

FIG. 4 illustrates one panel 310 forming the light source module 300. As mentioned above, the panel 310 may be a printed circuit board (PCB). A plurality of light-emitting elements 312 (refer to FIG. 6) may be mounted on the panel 310 so as to be disposed in one direction to form pixels, thereby constituting the light-emitting element array 311. Here, a light-emitting diode (LED) may be used as the light-emitting element.

That is, the light-emitting elements 312 are disposed in one direction on one panel 310 to form individual pixels, with the result that the light-emitting element array 311 may be provided so as to be linearly mounted.

FIG. 5 illustrates the rear surface of the panel 310. Drivers 314 for driving the light-emitting elements 312 may be mounted on the rear surface of the panel 310, which constitutes the light source module.

Since the drivers 314 are mounted on the rear surface of the panel 310, as described above, the drivers 314 may not interfere with a light-emitting surface, the influence on light emission from the light sources (the light-emitting elements) 312 due to interference may be minimized, and the area of the panel 310 may be minimized. The panel 310, having a small area, may improve the transparency of the display.

Meanwhile, the front surface of the panel 310, on which the light-emitting element array 311 is mounted, may be processed into a dark color (e.g. black) in order to improve the contrast ratio and the color expression of the display, thereby maximizing the effect of the light sources.

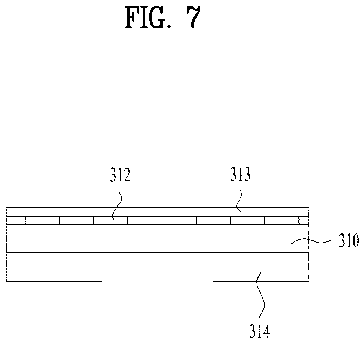

FIG. 6 is an enlarged view of portion A in FIG. 4, and FIG. 7 is a cross-sectional view of the light source module according to the present disclosure.

Referring to FIG. 6, it can be seen that the individual light-emitting elements 312 are mounted linearly in one direction (the longitudinal direction of the panel). In this case, a protective portion 313 may be located outside the light-emitting elements 312 in order to protect the light-emitting elements 312.

Red, green, and blue light-emitting elements 312 may form one pixel in order to realize natural colors, and the individual pixels may be mounted in one direction on the panel 310.

Referring to FIG. 7, the light-emitting elements 312 may be protected by the protective portion 313. Further, as described above, the drivers 314 may be mounted on the rear surface of the panel 310, and may drive the light-emitting elements 312 in units of pixels or subpixels. In this case, one driver 314 may individually drive at least one pixel.

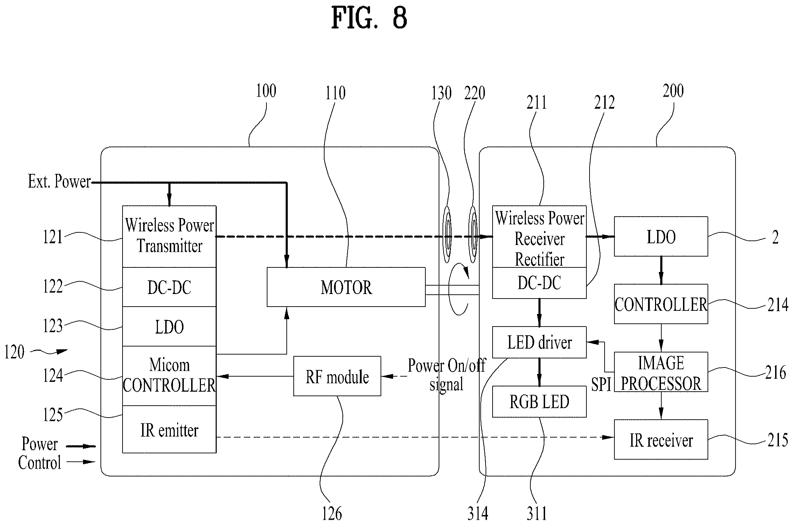

FIG. 8 is a block diagram of the rotating display device according to the present disclosure.

Hereinafter, a configuration for driving the rotating display device will be described briefly with reference to FIG. 8. Although this configuration will be described with reference to the first embodiment described above, the same may also be identically applied to the second embodiment.

First, a driving circuit 210 may be mounted to the fixed portion 100. The driving circuit 120 may include a power supply. The driving circuit 120 may include a wireless power transmitter 121, a DC-DC converter 122, and a voltage generator 123 for supplying individual voltages.

External power may be supplied to the driving circuit 120 and the motor 110.

In addition, an RF module 126 may be provided at the fixed portion 100, so that the display may be driven in response to a signal transmitted from the outside.

Meanwhile, a means for sensing rotation of the rotary portion 200 may be provided at the fixed portion 100. Infrared radiation may be used to sense rotation. Accordingly, an IR emitter 125 may be mounted to the fixed portion 100, and an IR receiver 215 may be mounted to the rotary portion 200 at a position corresponding to the IR emitter 125.

In addition, a controller 124 may be provided at the fixed portion 100 in order to control the driving circuit 120, the motor 110, the IR emitter 125, and the RF module 126.

Meanwhile, the rotary portion 200 may include a wireless power receiver 211 for receiving a signal from the wireless power transmitter 121, a DC-DC converter 212, and a voltage generator (LDO) 213 for supplying individual voltages.

The rotary portion 200 may be provided with an image processor 216 in order to realize an image through the light-emitting element array using RGB data of an image to be displayed. The signal processed by the image processor 216 may be transmitted to the drivers 314 of the light source module, and thus an image may be realized.

In addition, a controller 214 may be mounted to the rotary portion 200 in order to control the wireless power receiver 211, the DC-DC converter 212, the voltage generator (LDO) 213, the IR receiver 215, and the image processor 216.

The image processor 216 may generate a signal for controlling light emission from the light sources of the light source module based on data of an image to be output. At this time, the data for light emission from the light source module may be internal data or external data.

The data stored in the internal device (the rotary portion 200) may be image data pre-stored in a storage device, such as a memory (an SD-card) mounted together with the image processor 216. The image processor 216 may generate a light emission control signal based on the internal data.

The image processor 216 may transmit control signals to the drivers 314 so that the first light-emitting element arrays 311, 321, and 331 and the second light-emitting element arrays 411, 421, and 431 display image data of a specific frame in a delayed manner.

Further, the image processor 216 may transmit control signals to the drivers 314 so that the respective light-emitting element arrays 311 and 321 are sequentially driven.

Meanwhile, the image processor 216 may receive image data from the fixed portion 100. At this time, external data may be output through an optical data transmission device, such as a photo coupler, or an RF-type data transmission device, such as a Bluetooth or Wi-Fi device.

In this case, as mentioned above, a means for sensing rotation of the rotary portion 200 may be provided. That is, the IR emitter 125 and the IR receiver 215 may be provided as a means for detecting the rotational position (speed) of the rotary portion 200, such as an absolute rotational position or a relative rotational position, in order to output light source data suitable for each rotational position (speed) during rotation of the rotary portion 200. Alternatively, this function may also be achieved using an encoder, a resolver, or a Hall sensor.

Meanwhile, data required to drive the display may be transmitted as a signal in an optical manner at low cost using the principle of a photo coupler. That is, if the fixed portion 100 and the rotary portion 200 are provided with a light emitter and a light receiver, reception of data is continuously possible even when the rotary portion 200 rotates. Here, the IR emitter 125 and the IR receiver 215 described above may be used to transmit data.

As described above, power may be transferred between the fixed portion 100 and the rotary portion 200 in a wireless power transfer (WPT) manner.

Wireless power transfer enables the supply of power without connection of a wire using a resonance phenomenon of a coil.

To this end, the wireless power transmitter 121 may convert power into an RF signal of a specific frequency, and a magnetic field generated by current flowing through the transmission coil 130 may generate an induced current in the reception coil 220.

At this time, the natural frequency of the coil and the transmission frequency for transferring actual energy may differ from each other (a magnetic induction method).

Meanwhile, the resonant frequencies of the transmission coil 130 and the reception coil 220 may be the same (a magnetic resonance method).

The wireless power receiver 211 may convert the RF signal input from the reception coil 220 into direct current, and may transmit required power to a load.

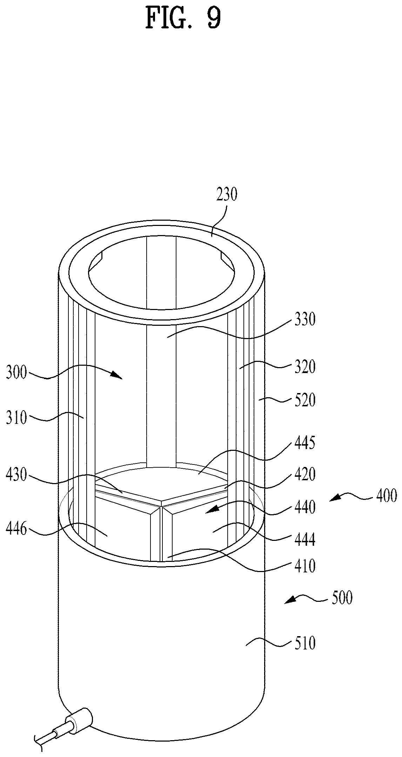

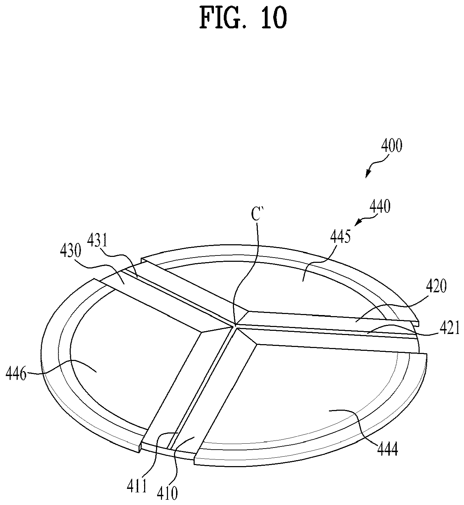

FIG. 9 is an external perspective view showing a rotating display device according to a second embodiment of the present disclosure. FIG. 10 is a perspective view showing a second light source module of the rotating display device according to the second embodiment of the present disclosure.

FIG. 9 shows a cylindrical rotating display device including the first light source module 300, in which each of the light-emitting element arrays 311, 321, and 331 (refer to FIG. 4; hereinafter, referred to as the first light-emitting element array) is provided on each of one or more panels 310, 320, and 330 (hereinafter, referred to as the first panel), disposed along a virtual cylindrical outer circumferential surface, in the longitudinal direction of each of the first panels, and the second light source module 400 including one or more second panels 410, 420, and 430 and the second light-emitting element arrays 411, 421, and 431 located on the second panels 410, 420, and 430, the second light-emitting element arrays 411, 421, and 431 including individual pixels disposed therein in the longitudinal direction of the second panels 410, 420, and 430.

Hereinafter, the second embodiment will describe an example in which the second light source module 400 is provided on the lower panel 440 installed on the upper frame 202 located at the lower side of the rotary portion 200 with reference to FIGs. 9 and 10. However, as described in another embodiment below, the second light source module 400 may be further provided on an upper panel 450 installed on the cover frame 230 of the rotary portion 200. The upper panel 450 will be described in connection with another embodiment.

As shown in the drawing, another aspect different from the first embodiment described with reference to FIG. 1 is that the second light source module 400 may have a conical shape. That is, the lower panel 440 provided as the second light source module 400 may have a conical shape. In this case, a central point C' of the lower panel 440 may have a height different from that of a peripheral portion thereof. That is, when the second light source module 400 is implemented as the lower panel 440, the central point C' of the lower panel 440 may have a height higher than that of peripheral portions thereof. Accordingly, the lower panel 440 may have a conical shape.

In this case, the second light-emitting element arrays 411, 421, and 431 may be radially disposed on the conical lower panel 440 from the central point C' of the lower panel 440. That is, the second light source module 400 may include the second panels 410, 420, and 430 radially provided therein, and the second light-emitting element arrays 411, 421, and 431 may be disposed in the longitudinal direction of the second panels 410, 420, and 430, respectively.

The number of second panels 410, 420, and 430 and second light-emitting element arrays 411, 421, and 431 may be the same as the number of first light-emitting element arrays 311, 321, and 331. Since the second light-emitting element arrays 411, 421, and 431 rotate at substantially the same rotational speed as the first light-emitting element arrays 311, 321, and 331, it is preferable that the second light-emitting element arrays 411, 421, and 431, and the first light-emitting element arrays 311, 321, and 331 be provided in the same number.

For example, as described in the second embodiment, when the number of first light-emitting element arrays 311, 321, and 331 is three, three second light-emitting element arrays 411, 421, and 431 may be provided.

In addition, as shown in the drawing, each of the second light-emitting element arrays 411, 421, and 431 may be disposed between adjacent first light-emitting element arrays 311, 321, and 331.

The lower panel 440 may be formed by respective partial panels 444, 445, and 446, the respective partial panels 444, 445, and 446 having arc shapes and being coupled to each other to form a conical shape. That is, as shown in FIG. 10, the three partial panels 444, 445, and 446 having the arc shapes and the second panels 410, 420, and 430 located therebetween may be coupled to each other to form the lower panel 440.

Each of the three partial panels 444, 445, and 446 having the arc shapes may be inclined from the central point C' of the lower panel 440 to the peripheral portion thereof. That is, since the partial panels 444, 445, and 446 are coupled to each other to form the conical shape of the lower panel 440, each of these partial panels 444, 445, and 446 may have an inclined surface.

Accordingly, when the second light source module 400 is viewed from the side surface of the rotating display device, the visibility of the second light source module 400 may be improved.

As a result, according to an implementation example of a display screen, the rotating display device may further improve a three-dimensional effect by implementing a screen display on the surface of the cylindrical rotary body and the inclined surface on the bottom side of the rotary body.

Since other parts not described herein may be the same as those of the first embodiment, a redundant description thereof will be omitted.

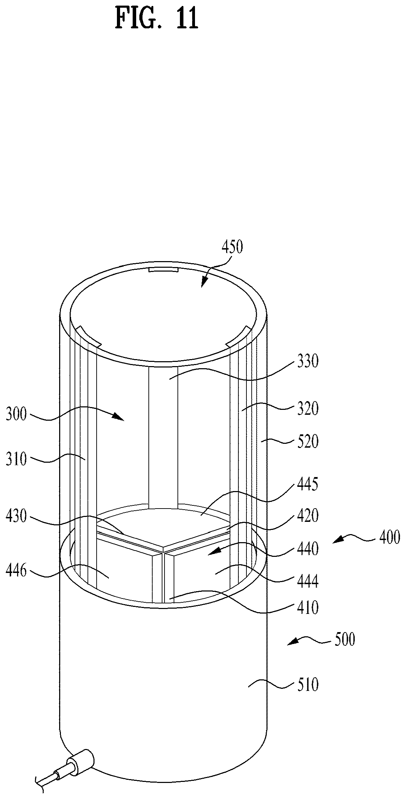

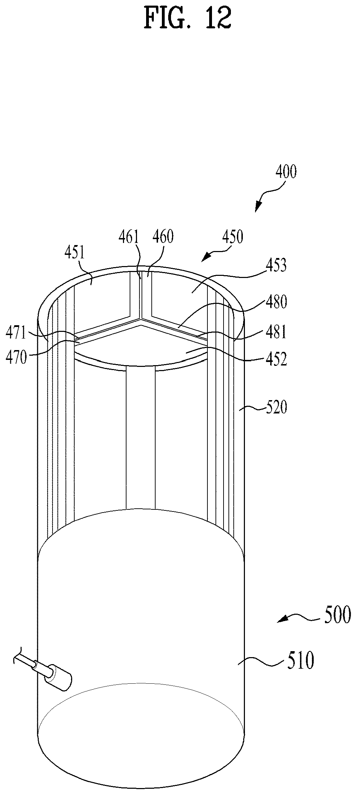

FIG. 11 is a perspective view of a rotating display device according to a third embodiment of the present disclosure, seen from above. FIG. 12 is a perspective view of the rotating display device according to the third embodiment of the present disclosure, seen from below. FIG. 13 is a side view of the rotating display device according to the third embodiment of the present disclosure.

FIG. 11 shows a cylindrical rotating display device including the first light source module 300 in which each of the light-emitting element arrays 311, 321, and 331 (refer to FIG. 4; hereinafter, referred to as the first light-emitting element array) is provided on each of one or more panels 310, 320, and 330 (hereinafter, referred to as the first panel), disposed along a virtual cylindrical outer circumferential surface, in the longitudinal direction of each of the first panels, and the second light source module 400 including one or more second panels 410, 420, and 430 and the second light-emitting element arrays 411, 421, and 431 located on the second panels 410, 420, and 430, the second light-emitting element arrays 411, 421, and 431 including individual pixels disposed therein in the longitudinal direction of the second panels 410, 420, and 430.

Here, the second light source module 400 may be provided on the lower panel 440 installed on the upper frame 202 located at the lower side of the rotary portion 200 and the upper panel 450 installed on the cover frame 230 located at the upper side of the rotary portion 200.

Hereinafter, an example in which the second light source module 400 includes the lower panel 440 and the upper panel 450 will be described in detail with reference to FIGs. 11 and 13.

Here, the lower panel 440 may be the same as the case of the second embodiment described with reference to FIG. 9. That is, as shown in FIG. 11, the second light source module 400 may have a conical shape. That is, the lower panel 440 provided as the second light source module 400 may have a conical shape.

As shown in FIG. 9, the central point C' of the lower panel 440 may have a height different from that of a peripheral portion thereof. That is, when the second light source module 400 is implemented as the lower panel 440, the central point C' of the lower panel 440 may have a height higher than that of peripheral portions thereof. Accordingly, the lower panel 440 may have a conical shape.

Meanwhile, the upper panel 450 may also be provided on the upper panel 450, which is installed on the cover frame 230, which is located at the upper side of the rotary portion 200.

The upper panel 450 may have a conical shape, like the lower panel 440. Since the upper panel 450 is installed so as to be oriented downwards on the cover frame 230 located at the upper side of the rotary portion 200, the upper panel 450 may have an inverted conical shape. However, depending on the case, of course, the upper panel 450 may have a disk shape, as shown in the case of the first embodiment.

Referring to FIG. 12, second light-emitting element arrays 461, 471, and 481 may be radially disposed on the conical-shaped upper panel 450 from the center of the upper panel 450. That is, the second light source module 400 may include second panels 460, 470, and 480 radially provided therein, and second light-emitting element arrays 461, 471, and 481 may be disposed in the longitudinal direction of the second panels 460, 470, and 480, respectively.

The number of second panels 460, 470, and 480 and second light-emitting element arrays 461, 471, and 481 may be the same as the number of first light-emitting element arrays 311, 321, and 331. Since the second light-emitting element arrays 461, 471, and 481 rotate at substantially the same rotational speed as the first light-emitting element arrays 311, 321, and 331, it is preferable that the second light-emitting element arrays 461, 471, and 481, and the first light-emitting element arrays 311, 321, and 331 be provided in the same number.

The upper panel 450 may be formed by respective partial panels 451, 452, and 453, the respective partial panels 451, 452, and 453 having arc shapes and being coupled to each other to form a conical shape. That is, as shown in FIG. 12, the three partial panel 451, 452, and 453 having the arc shapes and the second panels 460, 470, and 480 located therebetween may be coupled to each other to form the upper panel 450.

Each of the three partial panels 451, 452, and 453 having the arc shapes may be inclined from the center of the upper panel 450 to the peripheral portion thereof. That is, since the partial panels 441, 452, and 453 are coupled to each other to form the conical shape of the upper panel 450, the partial panels 451, 452, and 453 may have inclined surfaces.

Accordingly, when the second light source module 400 is viewed from the side surface of the rotating display device, the visibility of the second light source module 400 may be improved.

As a result, according to an implementation example of a display screen, the rotating display device may further improve a three-dimensional effect by implementing a screen display on the surface of the cylindrical rotary body and the inclined surfaces of the bottom side of the rotary body and the upper side of the rotary body.

Since other parts not described herein may be the same as those of the first and second embodiments, a redundant description thereof will be omitted.

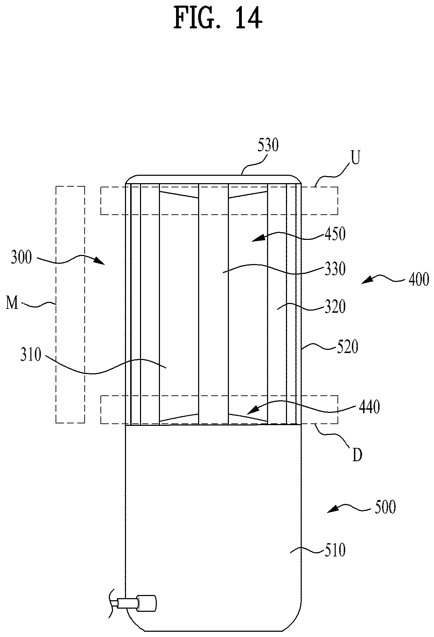

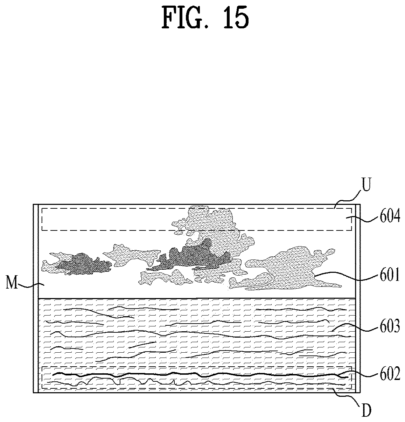

FIGs. 14 and 15 are views showing an example of a screen configuration of the rotating display device according to the third embodiment of the present disclosure.

For example, the first light-emitting module 300 may form a central screen, and the upper panel 450 of the second light-emitting module 400 and the lower panel 440 of the second light-emitting module 400 may form a background screen.

That is, as shown in FIGs. 14 and 15, the first light-emitting module 300 may form a central screen M, the upper panel 450 of the second light-emitting module 400 may form an upper screen U of the screen, and the lower panel 440 of the second light-emitting module 400 may form a lower screen D of the screen.

Referring to FIG. 15, in the case of a configuration of the screen 600 using the rotating display device of the present disclosure, the central screen M expressing a cloud 601 and an ocean 603 in the center of the screen may be displayed using the first light-emitting module 300.

In addition, the upper screen U including a sky 604 in the upper portion of the screen may be displayed using the upper panel 450 of the second light-emitting module 400, and the lower screen D including a sand bar 602 in the lower portion of the screen may be displayed using the lower panel 440 of the second light-emitting module 400.

Meanwhile, depending on the case, only the upper panel 450 of the second light-emitting module 400 and the lower panel 440 of the second light-emitting module 400 may be driven in the state in which the first light-emitting module 300 is not driven.

The rotating display device including the first light source module 300 and the second light source module 400, rotatable as described above, may improve the three-dimensional effect by implementing the screen display on the surface of the cylindrical rotary body and the bottom surface of the rotary body.

Therefore, according to the implementation example of the display screen, the rotating display device may further improve the three-dimensional effect by implementing the screen display on the surface of the cylindrical rotary body and the inclined surface on the bottom side of the rotary body.

Therefore, according to the implementation example of the display screen, the rotating display device may further improve the three-dimensional effect by implementing the screen display on the surface of the cylindrical rotary body and the inclined surfaces of the bottom side of the rotary body and the upper side of the rotary body.

The above description is only an example of a technical idea of the present disclosure, and those skilled in the art to which the present disclosure pertains will appreciate that various modifications and variations are possible without departing from the scope and spirit of the present disclosure.

Therefore, the embodiments disclosed in the present disclosure are not intended to limit the technical idea of the present disclosure, and the scope of the technical idea of the present disclosure is not limited by these embodiments.

The protection scope of the present disclosure should be interpreted by the following claims, and all technical ideas within the scope equivalent thereto should be construed as being included in the scope of the present disclosure.

### INDUSTRIAL APPLICABILITY

According to the present disclosure, it is possible to provide a rotating display device using a light-emitting diode (LED), which is a semiconductor light-emitting element.

## Claims

1. A rotating display device using a light-emitting element, the rotating display device comprising:
a fixed portion comprising a motor;
a rotary portion located on the fixed portion and coupled to a rotary shaft of the motor so as to rotate;
a first light source module disposed at the rotary portion, the first light source module comprising one or more first panels, disposed on an outer rotational circumference of the rotary portion in the same direction as the rotary shaft, and wherein each first panel comprises a first light-emitting element array comprising individual pixels disposed along a longitudinal direction of the first panel; and
a second light source module disposed at the rotary portion, the second light source module comprising one or more second panels, disposed in a direction perpendicular to the rotary shaft, wherein each second panel comprises a second light-emitting element array comprising individual pixels disposed on the second panel.

2. The rotating display device of claim 1, wherein the second light source module has a disk shape.

3. The rotating display device of claim 2, wherein each second light-emitting element array is radially disposed from a center of the second light source module.

4. The rotating display device of claim 3, wherein a number of second light-emitting element arrays is the same as a number of first light-emitting element arrays.

5. The rotating display device of claim 4, wherein each of the second light-emitting element arrays is located between the adjacent first light-emitting element arrays.

6. The rotating display device of claim 1, wherein the one or more first panels of the light source module extends between a first side and a second side of the rotary portion.

7. The rotating display device of claim 6, wherein the one or more second panels comprise:
one or more upper panels located at the first side of the rotary portion, and
one or more lower panels located at the second side of the rotary portion.

8. The rotating display device of claim 1, wherein the one or more second panels are inclined with respect to a direction perpendicular to the rotary shaft.

9. The rotating display device of claim 8, wherein the second panel has a central portion and a peripheral portion different from each other in height in the direction perpendicular to the rotary shaft.

10. The rotating display device of claim 1, wherein the second light source module has a conical shape.

11. A rotating display device using a light-emitting element, the rotating display device comprising:
a fixed portion comprising a motor;
a rotary portion located on the fixed portion and coupled to a rotary shaft of the motor so as to rotate;
a first light source module disposed at the rotary portion, the first light source module comprising one or more first panels each elongated between a first side and a second side of the rotary portion, wherein each first panel comprises a first light-emitting element array comprising individual pixels disposed along a longitudinal direction of the first panel; and
a second light source module disposed at the rotary portion, the second light source module comprising one or more second panels, disposed on at least one of the first side or the second side of the rotary portion, wherein each second panel comprises a second light-emitting element array comprising individual pixels disposed on the second panel.

12. The rotating display device of claim 11, wherein the first light source module is disposed on a virtual cylindrical outer circumferential surface formed by the rotary portion in the same direction as the rotary shaft.

13. The rotating display device of claim 11, wherein the second light source module is disposed in a direction perpendicular to the rotary shaft.

14. The rotating display device of claim 11, wherein the second light source module has a disk shape or a conical shape.

15. The rotating display device of claim 14, wherein each second light-emitting element array is radially disposed from a center of the second light source module.

16. The rotating display device of claim 15, wherein a number of second light-emitting element arrays is the same as a number of the first light-emitting element arrays.

17. The rotating display device of claim 16, wherein each of the second light-emitting element arrays is located between the adjacent first light-emitting element arrays.

18. The rotating display device of claim 11, wherein the one or more second panel comprise:
one or more upper panels located at the first side of the rotary portion, and
one or more lower panels located at the second side of the rotary portion.

19. The rotating display device of claim 11, wherein the one or more second panels are inclined with respect to a direction perpendicular to the rotary shaft.

20. The rotating display device of claim 19, wherein the second panel has a central portion and a peripheral portion different in height in the direction perpendicular to the rotary shaft.
